**Europäisches Patentamt**

**European Patent Office**

**Office européen des brevets**

(19)

(11) Publication number: **0 081 295**

**A1**

(12) # EUROPEAN PATENT APPLICATION

(21) Application number: **82305943.1**

(22) Date of filing: **08.11.82**

(51) Int. Cl.³: **G 01 R 31/28**

(30) Priority: **12.11.81 US 320392**

(43) Date of publication of application:
**15.06.83 Bulletin 83/24**

(84) Designated Contracting States:
**DE FR GB NL**

(71) Applicant: **Hughes Aircraft Company
Centinela & Teale Streets
Culver City California 90230(US)**

(72) Inventor: **Wolf, Edward D.
8 Highgate Circle
Ithaca New York 14850(US)**

(72) Inventor: **Ozdemir, Faik Sinasi
3217 Radcliffe
Thousand Oaks California 91360(US)**

(74) Representative: **Colgan, Stephen James et al,
CARPMAELS & RANSFORD 43 Bloomsbury Square
London WC1A 2RA.(GB)**

(54) **Intelligent probe for fast microcircuit internal node testing.**

(57) Internal nodes of an integrated circuit chip are tested by applying a thinly focused electron beam to the node under control of a computer and then sensing secondary electron emission. The computer controls the application of test signals to the peripheral pad connections on the chip and intelligently selects a small number of nodes for testing which are the likeliest nodes to indicate circuit failure.

Fig. 1.

Croydon Printing Company Ltd.

# INTELLIGENT PROBE FOR FAST MICRO-CIRCUIT INTERNAL NODE TESTING

## BACKGROUND ART

The reliability of integrated circuits having microscopic geometries is currently limited by the methods in which such integrated circuits are tested. Specifically, external pads at the edge of each integrated circuit have microscopic dimensions which permit electrical connection to the circuit, while the internal nodes of the circuit which may number in the hundreds of thousands remain physically inaccessible because of their small geometry.

Accordingly, testing is limited to signal detection at the input/output section of the circuit comprising the pads at the periphery of the circuit. Therefore, the internal nodes of the circuit are not tested directly, thus limiting the reliability of the test results obtained using current methods.

Currently, one of the few practical uses found for electron beam technology in integrated circuit production is the exposure and definition of photolithographic masks by the use of electron beams. Such systems are well known and many include the feature of photolitographic mask definition by E beam movement and blanking in the manner of a video or cathode ray tube system.

In summary, no practical method exists in the prior art for production testing of internal nodes of complex integrated circuits having both high system through-put and reliability.

## SUMMARY OF THE INVENTION

The present invention is an intelligent probe for high speed access and testing of internal nodes of a complex integrated circuit. The probe intelligently chooses a limited number of the internal nodes most likely to indicate circuit failure so as to minimize the number of nodes tested while maximizing reliability of the results. The probe comprises an artificial intelligence which understands the design and operation of the integrated circuit under test, the intelligence being embodied in a programmed computer associated with the probe. The invention further comprises means for accessing the peripheral pads of the integrated circuit and for applying the proper circuit biases, clock signals and test signals to the integrated circuit under control of the computer. The probe is preferably an electron beam apparatus for focusing and directing the electron beam to the internal nodes selected by the computer and detecting secondary electron emission therefrom. The probe may further comprise means for selecting subsequent nodes for testing in real time by evaluation of on-going test results. It is understood that the movement of the electron beam between the selected internal nodes of the circuit and the operation of the computer to select those nodes are decisions which may be made in a matter of microseconds or milliseconds. The intelligent understanding of the circuit embodied in the computer may be derived from the circuit design, results from computerized circuit simulations and statistical algorithms for evaluating the likeliest internal circuit nodes to fail.

The electron beam testing in this invention is preferably performed immediately after the metal interconnections have been photolithographically defined on the integrated circuit and before the overlying glass layers are deposited. An electron beam, when focused on a single node defined by the metal, creates secondary electron emission having a flux determined by the potential of the metal node on which the electrons of the primary beam impinge. A suitable detector observes the secondary emission electron flux, permitting the computer to sense and store the voltage of the node under test.

In one alternative embodiment of the invention, the computer reacts to the observed internal node voltage to determine the next step in testing. The next step may be a selection by the computer of the next-likeliest node to indicate circuit failure.

A decision that the entire integrated circuit under test is "good" may be made by the computer after it determines that a sufficient number of selected nodes have been tested to indicate non-failure with a particular tolerance and confidence.

One advantage of the invention is that the intelligent probe does not capacitively load any of the internal nodes nor does it damage them. At the same time the probe has a submicrometer diameter and is easy to position. Because of the high speed with which the nodes may be selected and tested, use of the invention on a production line having high system through-put in place of conventional testing methods is cost effective and inherently more reliable.

## DESCRIPTION OF THE DRAWINGS

The invention is best understood by reference of the accompanying drawings of which:

FIG. 1 is a block diagram illustrating the intelligent probe testing system of the present invention;

FIG. 2 is a block diagram illustrating the elements of the central computer of FIG. 1;

FIG. 3 is a block diagram illustrating the elements of the satellite computer of FIG. 1; and

FIG. 4 is a block diagram illustrating the beam position control hardware of FIG. 1.

## DETAILED DESCRIPTION

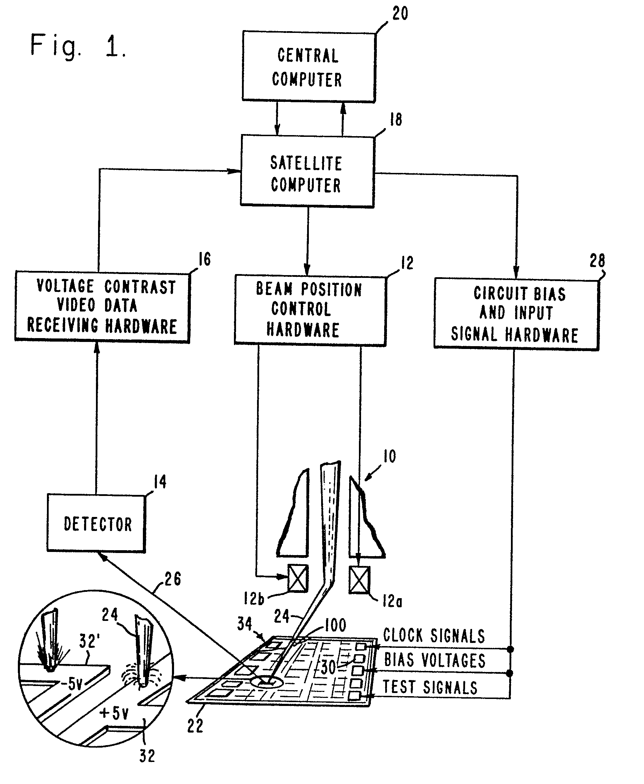

Referring to FIG. 1, the intelligent probe of the present invention includes an electron beam generator 10 and associated beam position control hardware 12 including, among other things, deflection coils 12a, b, a secondary electron emission detector 14 and associated voltage contrast video data receiving hardware 16. A satellite computer 18 controls the beam position hardware 12 and the voltage contrast hardware 16. A central computer 20 embodies the intelligent understanding of an integrated circuit chip 22 which is under test. An electron beam 24 from the beam generator 10 is directed toward the chip 22 to create secondary electron emission 26 received at the detector 14. The integrated circuit chip 22 is activated by means of circuit bias and input signal hardware 28 controlled by the satellite computer 18. The circuit bias hardware 28 generates clock signals, test signals and bias voltages which are applied to appropriate ones of a plurality of peripheral metallic pads 30 located along the perimeter edge of the integrated circuit 22.

The integrated circuit 22 is tested immediately after the metal lines 34, comprising the microscopic interconnections of the integrated circuit 22, have been photolithographically defined. The metal lines comprise a plurality of nodes 32 from which the central computer 20 may select individual nodes for sequential testing. Using well-known techniques, the metal pattern serves as a means for registering the geometry of the circuit 22 to the beam position control hardware 12.

When the central computer has identified a particular node 32 to be tested, it directs the circuit bias input signal hardware 28 to apply appropriate clock signals, bias voltages and test signals to the appropriate ones of the pads 30 and causes the beam position control hardware to direct the electron beam 24 to focus on the particular selected node 32. Some electrons are emitted from the node 32, and form a secondary emission of electrons 26. The secondary electron emission 26 is sensed by the detector 14, the detector 14 generating an output voltage proportional to the flux of electrons in the secondary electron emission 26. The flux of the electrons and the resulting output voltage generated by the detector 14 are proportional to the potential of the selected node 32. Accordingly, the receiving hardware 16 converts the voltage signal from the detector 14 to a number corresponding to the actual voltage of the node 32. The satellite computer 18 feeds this data to the central computer 20. The central computer 20 uses its stored information defining the operation and performance of the circuit 22 to control the testing.

As is well known to those skilled in the art, if the node 32 is raised to a positive potential (for example +5 volts), the amount of secondary electron emission reaching the detector 14 will be reduced proportionately. On the other hand, if another node 32' is selected which happens to be at a negative potential (for example, -5 volts), the secondary emission electron flux will be greater in proportion to the negative potential. Thus, the secondary emission electron flux increases with the increase in negative voltage on the selected node.

## BEST MODE

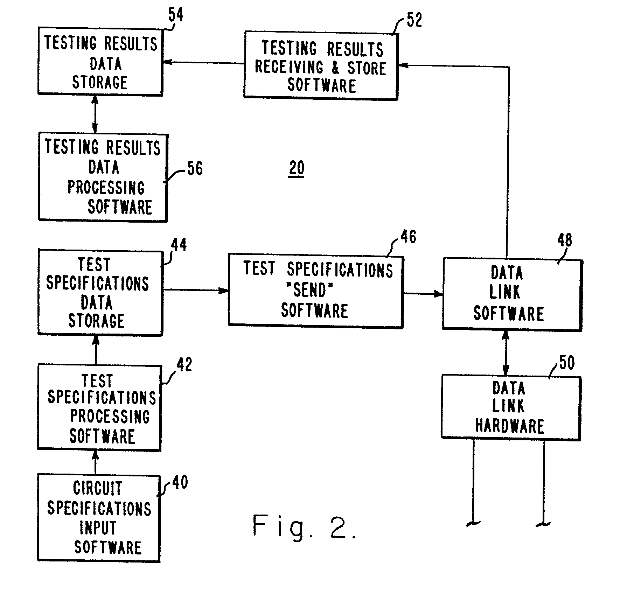

The central computer 20 is illustrated in FIG. 2. The central computer 20 stores the circuit specifications in the form of input software 40. The test specifications are processed by processing software 42 and stored in memory 44, from which they may be broadcast via test specifications send software 46 through data link software 48 and data link hardware 50. The test specifications may include software and data defining the circuit design, the mask geometry of each layer of the integrated circuit, and performance data derived, for example, from computer simulations of the circuit performance. Furthermore, the test specifications may include statistical software capable of identifying a group of nodes in the circuit which are the likeliest nodes to indicate circuit failure based upon circuit performance data from simulations and past test results.

Test results received from the receiving hardware 16 by the satellite computer 18 are sent through the data link 50 to the central computer 20 where the results are stored and received by receive and store software 52 and stored in memory 54. The testing results are processed by processing software 56.

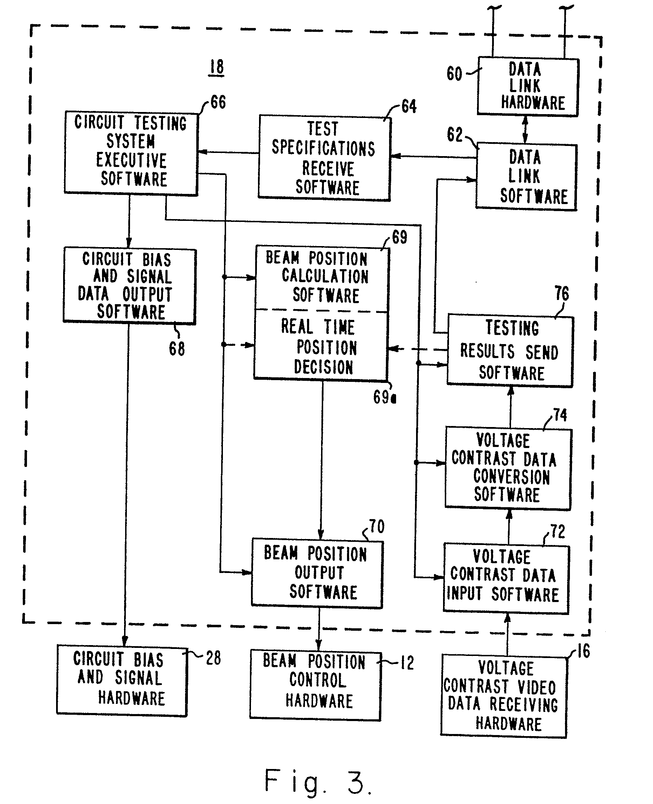

Referring to FIG. 3, the satellite computer 18 communicates with the central computer 20 via data link hardware 60 and data link software 62. The test specifications transmitted by the send software 46 of the central computer are received in the satellite computer by test specifications receive software 64, generating instructions to be implemented by circuit testing system executive software 66. In response, the executive software 66 issues instructions performed by circuit bias and signal data output software 68, beam position output software 70 and voltage contrast data input software 72. The circuit bias and signal data output software 68 causes the circuit bias and signal hardware 28 to generate the appropriate clock signals, bias voltages and test signals originally defined in the test specifications stored in memory 44. The beam position output software 70 causes the beam position control hardware 12 to direct the electron beam 24 to the selected node 32 in accordance with the test specifications stored in memory 44. The voltage contrast data input software 72 receives the data from the voltage contrast video data receiving hardware 16. The data is then converted to a format compatible with the overall system software by voltage contrast data conversion software 74, and then made available to test and result data send software 76. The executive software 66 enables the transmission of the testing results data by the send software 76 to the data link software 62. Receipt and storage in the central computer 20 of the testing results transmitted by the send software 76 are controlled by the receipt and store hardware 52. The test results are transmitted to the processing software 56 of the central computer 20.

In one embodiment of the invention, the satellite computer 18 may make decisions in real time to alter the test sequence in response to on-going test results being received. The beam position calculation software 69, controlling the beam position output software 70, may include means 69a for immediate selection of a new node for testing in response to on-going test results. The position selection means 69a receives the testing results directly from the send software 76 and may alter the calculation of the beam position to address a different circuit node. This decision is preferably made under control of the executive software 66 in accordance with the test specifications from the receive software 64. In this alternative embodiment of the invention, the sequence of internal nodes 32 selected for testing may be altered in real time in light of unexpected test results transmitted by the send software 76. It should be understood that this decision-making process may, for a single node, consume a short period of time on the order of microseconds or milliseconds so that the overall testing of a single integrated circuit 22 would not be significantly delayed. It is contemplated that the alteration of the test sequence in real time may be designed to decrease the actual number of nodes to be tested without reducing the reliability of the test results.

One way of implementing the real time test sequence alteration means 69a using well-known techniques is to program into the computer 18 an expected voltage and tolerance for each node to be tested, together with instructions specifying an alternative sequence of nodes to be addressed if the detected voltage at that node falls outside the tolerance. For each node to be tested in the alternative test sequence, a voltage and tolerance, together with another alternative test sequence, would be programmed into the computer 18. It is contemplated that a large number of voltages and tolerances and alternative test sequences would be stored in the computer 18, corresponding to the number of nodes which might possibly be tested, thus establishing a logic tree in the computer 18 defining all possible permutations of the original test sequence. Depending upon which ones of the nodes are detected to have an out-of-tolerance voltage, the real time test sequence alteration means 69a may initiate any one of the test sequence permutations defined by the logic tree. This technique may be implemented by skilled programmers with the guidance of integrated circuit test engineers using ordinary techniques of systems analysis and programming well known in the art.

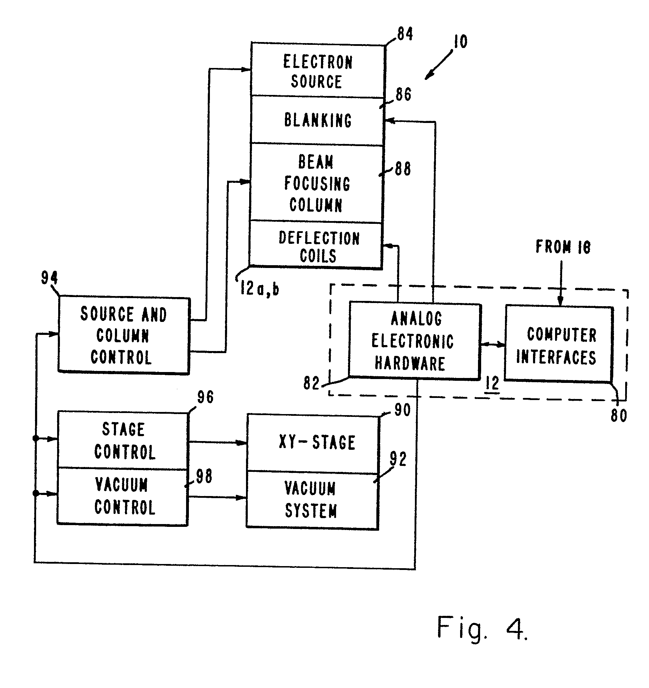

Referring to FIG. 4, the beam position control hardware 12 includes a computer interface 80 connected to receive a command signal from the satellite computer 18 and analog electronic hardware 82 controlling the electron beam generator 10. The electron beam generator 10 includes an electron source 84, means 86 for blanking the electron beam 22, a beam focusing column 88, deflection coils 12a, b, and a horizontally movable X-Y stage 90 contained in a vacuum system 92. The system 92 maintains the integrated circuit in a vacuum. The analog electronic hardware 82 directly controls the deflection coils 12a, b and the electron beam blanking means 86. The analog electronic hardware 82 also operates a source and column control 94 which, in turn, controls the electron source 84 and the beam focusing column 88. The analog electronic hardware 82 controls the XY stage 90 via stage controls 96 and controls the vacuum system 92 via vacuum controls 98.

The blanking means 86 may be operated to block the electron beam 24 periodically so that the electron beam is applied in short bursts. The blanking means 86 may be operated in synchronism with the clock signals and test signals applied by the circuit bias and input signal hardware 28 so that secondary electron emission 26 from the selected node 32 occurs only at those times when the node 32 is at a particular voltage. In this way, the signal from the detector 14 may be integrated over a number of samples by the receiving hardware 16 to enhance the signal-to-noise ratio. Also, the electron beam may be generated by the electron beam generator 10 using low beam accelerating voltages on the order of one kilovolt. The low voltage operation, together with the short pulse duration of the electron beam, minimizes the total amount of charge deposited on the selected node 32. This is a significant advantage because each of the selected nodes 32 has an extremely low capacitance. By minimizing the amount of electron charge induced during testing, the node is not capacitively loaded. This overcomes a problem plaguing prior art testing methods.

In one example, the beam current may be .1 nano-amperes and the beam pulse duration may be 1 microsecond while the selected node may have a capacitance of .1 picofarad. The resulting voltage variation would be one millivolt, as determined by the relationship $\delta V = IT/C$ where $\delta V$ is the voltage variation, I is the beam current, T is the pulse width of the electron beam and C is the capacitance of the node.

Preferably, the electron beam generator 10, including the electron source 84, the blanker 86, the deflection and focusing coils 12, the X-Y stage 90, the vacuum system 92 and their respective associated controls 94, 96, 98, are all embodied in a Cambridge S150N scanning electron microscope which is commercially available, and is well known among skilled workers in the art. The control computer 20 and the satellite computer 18 are each preferably a Digital Equipment Corporation PDP 11/34 Minicomputer.

The secondary emission electron detector 14 is preferably a detector probe developed by Siemens A.G. in the German Federal Republic and is described in Feuerbach, Scanning Electron Microscopy, Volume 1, 1979, pages 285-318, FIG. 5, page 290. The Siemens detector probe is also described in Fazekas, et al., "Scanning Electron Beam Probes VLSI Chips", Electronics, July 14, 1981, pp. 105-112, at p. 109, FIG. 5.

Accurate placement of the beam 24 by the position control hardware 12 onto a particular location on the chip 22 is made possible by electron beam registration of the beam position control hardware 12 to the surface topography of the chip 22. Electron beam registration is a well-known technique. The preferred method of electron beam registration involves the use of very small alignment marks (not shown) accurately placed in predetermined locations on the surface of the chip 22.

The marks comprise a material such as gold having a different atomic number from the substrate material. The orientation of the beam 24 is duly recorded when it strikes the alignment mark. The secondary electron emission flux changes whenever the beam 24 strikes the alignment mark, due to the different atomic number of the alignment marker material, this change in flux signaling registration of the beam to the marker, which is noted by the computers 18, 20.

Synchronization of the blanking means 86 with the test signals and clock signals applied to the chip 22 under test has been described. Such a technique may be termed "dynamic testing", since real operating conditions in the chip 22 are simulated. However, the invention is also useful in static testing in which constant voltages are applied to all of the pads 30, so that no simulation of actual operating conditions is made.

The invention may also be used to test a very large number of arbitrarily chosen circuit nodes in the chip 22 without any intelligent selection. For example, it may, in some rare instances, be desirable to test nearly all of the circuit nodes of the circuit chip 22.

The invention encompasses other embodiments not specifically described herein. For example, a laser may be used in place of the electron beam generator 10 to illuminate the internal nodes of the integrated circuit under test. In order to detect node voltage, a liquid crystal layer 100 may be placed temporarily over the surface of the integrated circuit, and the intensity of reflection of the laser beam by the liquid crystal 100 would indicate the voltage of the underlying node addressed by the beam. As in the case of the electron beam detection performed in the preferred embodiment of the invention, the laser beam reflected from the liquid crystal layer 100 is detected as emitted radiation from the vicinity of the underlying node addressed by the laser beam.

It is believed that the foregoing intelligent probe system of this invention is the first practical system useful in competitive commercial production lines for testing internal nodes of integrated circuits at a low cost. The computers 18, 20 provide full automation. The small beam diameter and positioning hardware make the beam and probe easy to position quickly in an area less than 1 square micrometer. The short pulse duration of the beam avoids significant capacitive loading of the circuit under test, while synchronization of the beam pulses with the test signals and clock signals applied to the circuit enhances the signal-to-noise ratio of the detected voltage signal.

## CLAIMS

What is Claimed is:

1. An apparatus for testing an integrated circuit chip having a plurality of internal nodes and a plurality of pads for external connection, comprising:
    means for illuminating a selected one of said nodes with a beam;
    means for simultaneously applying selected signals to selected ones of said pads; and
    means for detecting the magnitude of emitted radiation from the vicinity of said node and for deducing the electrical potential of said selected node from said radiation magnitude.

2. The beam tester of Claim 1 wherein said illuminating means comprise an electron beam source.

3. The beam tester of Claim 2 wherein said detecting means comprise means for detecting secondary electron emission from said selected node.

4. The beam tester of Claim 1 further comprising a computer for selecting said selected node, said computer including a memory storing data enabling said computer to intelligently select those nodes of said plurality of nodes which are the most likely to indicate failure of said integrated circuit chip.

5. The beam tester of Claim 4 wherein said computer means may select the next node to be illuminated in response to said electrical potential deducing means.

0081295

6. The beam tester of Claim 4 wherein said computer selects a limited number of said plurality of nodes based upon a statistical computation determining which of said plurality of nodes is the likeliest to indicate failure of said integrated circuit chip.

7. The beam tester of Claim 1 wherein said illuminating means comprises a laser and said detecting means comprises a liquid crystal layer overlying said integrated circuit chip and further including means for detecting laser beam reflection from said liquid crystal layer.

Fig. 1.

```
                                    ┌──────────────┐
  ┌──────────────┐54               52│   TESTING  RESULTS │
  │TESTING RESULTS│◄──────────────────│ RECEIVING & STORE │◄──────┐
  │     DATA      │                    │    SOFTWARE       │       │
  │   STORAGE     │                    └──────────────┘       │
  └──────────────┘                                                 │
         ▲                              20                         │
         │                                                         │
  ┌──────────────┐                                                 │
  │TESTING RESULTS│                                                │
  │     DATA      │ 56                                             │
  │  PROCESSING   │                                                │
  │   SOFTWARE    │                                                │
  └──────────────┘                                                 │
                                                                   │
  ┌──────────────┐44   ┌──────────────┐46   ┌──────────────┐48    │
  │    TEST       │     │ TEST SPECIFICATIONS│     │    DATA       │
  │SPECIFICATIONS │────►│     "SEND"    │────►│    LINK       │─────┘
  │    DATA       │     │   SOFTWARE    │     │  SOFTWARE     │
  │   STORAGE     │     └──────────────┘     └──────────────┘
  └──────────────┘                                  ▲
         ▲                                          │
  ┌──────────────┐42                         ┌──────────────┐50
  │    TEST       │                           │    DATA       │
  │SPECIFICATIONS │                           │    LINK       │
  │  PROCESSING   │                           │  HARDWARE     │
  │   SOFTWARE    │                           └──────────────┘
  └──────────────┘
         ▲
  ┌──────────────┐40
  │   CIRCUIT     │
  │SPECIFICATIONS │
  │    INPUT      │
  │   SOFTWARE    │
  └──────────────┘
```

Fig. 2.

Fig. 3.

4/4

Fig. 4.

0081295

**European Patent Office**

## EUROPEAN SEARCH REPORT

Application number

EP 82 30 5943

### DOCUMENTS CONSIDERED TO BE RELEVANT

| Category | Citation of document with indication. where appropriate, of relevant passages | Relevant to claim | CLASSIFICATION OF THE APPLICATION (Int. Cl. 3) |
|---|---|---|---|
| | --- | | G 01 R 31/28 |
| X | IEEE JOURNAL OF SOLID-STATE CIRCUITS, vol. SC-14, no. 2, April 1979 E. WOLFGANG et al. "Electron beam testing of VLSI circuits", pages 471-481 * Pages 472-473, paragraphe II, A. Physical principles * | 1-3,5 | |
| | --- | | |
| Y | IEEE JOURNAL OF SOLID-STATE CIRCUITS, vol. SC 14, no. 2, April 1979 | 4 | |
| | --- | | |
| Y | DE-A-2 629 097 (IBM) * Page 58, line 9 - page 66, line 18 ; figure 34 * | 4 | |
| | --- | | |
| P,Y | SOLID STATE ELECTRONICS, vol. 24, no. 12, Decembe r 1981, Exeter G. ASZODI et al. "High resolution thermal mapping of microcircuits using nematic liquid crystals", pages 1127-1133 * Page 1127 "Introduction" * | 7 | TECHNICAL FIELDS SEARCHED (Int. Cl. 3) G 01 R 31/28 |
| | --- -/- | | |

The present search report has been drawn up for all claims

| Place of search | Date of completion of the search | Examiner |
|---|---|---|
| BERLIN | 28-01-1983 | LEMMERICH J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82

## European Patent Office

## EUROPEAN SEARCH REPORT

### DOCUMENTS CONSIDERED TO BE RELEVANT

Page 2

| Category | Citation of document with indication, where appropriate, of relevant passages | Relevant to claim | CLASSIFICATION OF THE APPLICATION (Int. Cl. 3) |
|---|---|---|---|
| Y | SCIENTIFIC INSTRUMENTS, vol. 14, no. 1, January 1981, Dorking F.N. SINNADURAI et al. "Microcircuit operation observed by the stimulation of electro-optic responses in nematic liquid-crystals", pages 83-89 <br> * Pages 83-89 * <br><br> --- | 7 | |
| D,A | ELECTRONICS INTERNATIONAL, vol. 54, no. 14, July 1981, New York P. FAZEKAS et al. "Scanning electron beam probes VLSI chips", pages 105-112 <br> * Pages 105-112 * <br><br> ----- | | |

TECHNICAL FIELDS
SEARCHED (Int. Cl. 3)

The present search report has been drawn up for all claims

| Place of search | Date of completion of the search | Examiner |
|---|---|---|
| BERLIN | 28-01-1983 | LEMMERICH J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03.82